# EUROPEAN PATENT SPECIFICATION

(11) **EP 4 620 727 B1**
(45) Date of publication and mention of the grant of the patent: **09.09.2026**
(21) Application number: 25163551.2
(22) Date of filing: 13.03.2025
(51) Int. Cl.: B60L 58/16, B60L 53/65, B60L 53/80, H02J 7/47

(54) **INFORMATION PROCESSING APPARATUS, UPDATE METHOD, AND UPDATE PROGRAM**
INFORMATIONSVERARBEITUNGSVORRICHTUNG, AKTUALISIERUNGSVERFAHREN UND AKTUALISIERUNGSPROGRAMM
APPAREIL DE TRAITEMENT D'INFORMATIONS, PROCÉDÉ DE MISE À JOUR ET PROGRAMME DE MISE À JOUR

(30) Priority: 19.03.2024 JP 2024044195
(43) Date of publication of application: 24.09.2025
(73) Proprietor: Yokogawa Electric Corporation, Tokyo 180-8750 (JP)
(72) Inventor: TSUKANO, Masahito, Musashino-shi, Tokyo 180-8750, (JP); TAKENAKA, Kazuma, Musashino-shi, Tokyo 180-8750, (JP); TERAO, Minako, Musashino-shi, Tokyo 180-8750, (JP); TORAI, Soichiro, Musashino-shi, Tokyo 180-8750, (JP); NOGUCHI, Naoki, Musashino-shi, Tokyo 180-8750, (JP); YOSHITAKE, Satoshi, Musashino-shi, Tokyo 180-8750, (JP); OKANO, Jun, Wako-shi, Saitama 351-0193, (JP); ONOUE, Yukiko, Minato-ku, Tokyo 107-8556, (JP); TOMINAGA, Yuki, Wako-shi, Saitama 351-0193, (JP); OMICHI, Kaoru, Wako-shi, Saitama 351-0193, (JP)
(74) Representative: Winter, Brandl - Partnerschaft mbB

(56) References cited:
- JP-A- 2023 138 168
- US-A1- 2022 305 945
- US-A1- 2023 249 559

## Description

### BACKGROUND OF THE INVENTION

### 1. Field of the Invention

The present invention is related to an information processing apparatus, an update method, and an update program.

### 2. Description of the Related Art

In terms of achieving carbon neutrality, so- called xEVs that are electric vehicles driven by motors having electricity as a power source have come into wide use. With the spread of xEVs, work on battery sharing services has been promoted, the battery sharing services making batteries of xEVs swappable through provision of charging facilities where batteries with reduced amounts of charge and charged batteries are swapped and thereby implementing sharing of batteries.

However, in one aspect, in addition to genuine products manufactured by manufacturers, non-genuine products that are not genuine products are being sold and used as batteries for xEVs. For example, non-genuine products include imitation products each imitating, in addition to the appearance of a genuine module or a housing of a genuine pack, a two-dimensional code linked to management information, such as a battery passport, for management of a life cycle of the battery from procurement of materials to recycling.

Therefore, in a proposed technique, authenticity determination on whether or not a battery to be identified is a genuine product is executed by comparison between: battery characteristics of a genuine battery, the battery characteristics serving as reference; and battery characteristics measured from the battery to be identified.

Such battery characteristics of a battery are affected by deterioration over time. Therefore, in terms of implementing authenticity determination addressing the temporal change in battery characteristics of a battery, in one aspect, reference battery characteristics are updated over time.

Patent Document 1: Japanese Laid-open Patent Publication No. 2020-169932
Patent Document 2: Japanese Laid-open Patent Publication No. 2012-075212
Patent Document 3: Japanese Laid-open Patent Publication No. 2012-049030

However, increasing the frequency of update of the reference to be used in the authenticity determination does not necessarily improve the precision of the authenticity determination. For example, when battery characteristics of a battery are measured, disturbances from the surrounding environment other than the battery are superposed on the battery characteristics measured, and updating the reference frequently (for example, every time) with battery characteristics acquired completely newly may thus cause outliers to be set as the reference and reduce the precision of the authenticity determination. By contrast, if the frequency of update of the reference is too low, it will be difficult for the influence of the deterioration of the battery over time to be reflected in the reference and the precision of the authenticity determination may thus be reduced.

An object of the present invention is to optimize frequency of update of reference.

### SUMMARY OF THE INVENTION

According to one aspect of embodiments, an information processing apparatus includes: an acquisition unit configured to acquire a magnetic field distribution of a battery; and an update unit configured to update, by using the magnetic field distribution of the battery, a reference magnetic field distribution to be referred to in authenticity determination for the battery, in a case where a condition for updating the reference magnetic field distribution is satisfied upon acquisition of the magnetic field distribution of the battery.

According to one aspect of embodiments, an update method carried out by a computer includes: acquiring a magnetic field distribution of a battery; and updating, by using the magnetic field distribution of the battery, a reference magnetic field distribution to be referred to in authenticity determination for the battery, in a case where a condition for updating the reference magnetic field distribution is satisfied upon acquisition of the magnetic field distribution of the battery.

According to one aspect of embodiments, an update program causes a computer to execute a process including: acquiring a magnetic field distribution of a battery; and updating, by using the magnetic field distribution of the battery, a reference magnetic field distribution to be referred to in authenticity determination for the battery, in a case where a condition for updating the reference magnetic field distribution is satisfied upon acquisition of the magnetic field distribution of the battery.

### ADVANTAGEOUS EFFECTS OF INVENTION

An embodiment enables optimization of frequency of update of reference.

### BRIEF DESCRIPTION OF THE DRAWINGS

FIG. 1 is a diagram illustrating an example of a configuration of a battery sharing system;
FIG. 2 is a schematic diagram illustrating an example of a battery swap;
FIG. 3 is a schematic diagram illustrating an example of measurement of a magnetic field distribution of a battery;
FIG. 4 is a diagram illustrating one aspect of a problem solving approach;
FIG. 5 is a first block diagram illustrating an example of a functional configuration of a server apparatus;
FIG. 6 is a diagram illustrating an example of update of a swap interval for a battery;
FIG. 7 is a diagram illustrating an example of update of the number of executions of authenticity determination for the battery;
FIG. 8 is a schematic diagram illustrating an example of setting of a threshold;
FIG. 9 is a schematic diagram illustrating an example of update of reference;
FIG. 10 is a first flowchart illustrating an overall processing procedure;
FIG. 11 is a second block diagram illustrating an example of a functional configuration of a server apparatus;
FIG. 12 is a diagram illustrating an example of update of bringing-in frequency information;
FIG. 13 is a schematic diagram illustrating an example of setting of a threshold;
FIG. 14 is a second flowchart illustrating an overall processing procedure;
FIG. 15 is a diagram illustrating an example of application of a condition for updating reference; and
FIG. 16 is a diagram illustrating an example of a hardware configuration.

### DETAILED DESCRIPTION OF THE PREFERRED EMBODIMENTS

Modes (hereinafter, referred to as "embodiments") for implementing an information processing apparatus, an update method, and an update program, according to the present application will hereinafter be described by reference to the appended drawings. Each of the embodiments merely illustrates an example or aspect, and the scope of numerical values and functions and scenes of use are not to be limited by such illustration. The embodiments may be adaptively combined, so long as no contradiction arises in their processing from the combination.

### First Embodiment

### Overall Configuration

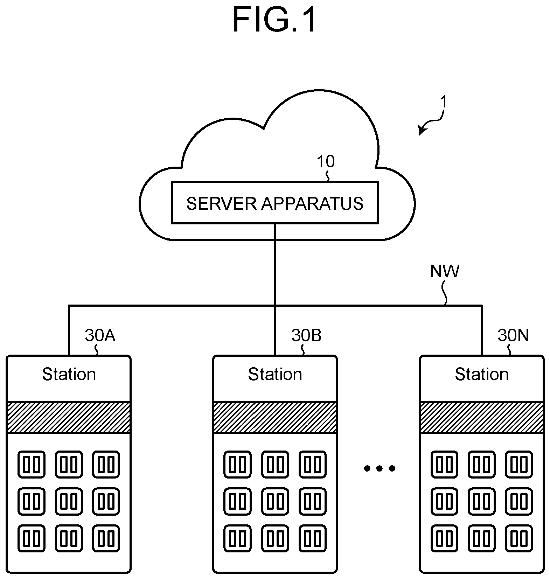

FIG. 1 is a diagram illustrating an example of a configuration of a battery sharing system. A battery sharing system 1 illustrated in FIG. 1 provides a battery sharing service that implements sharing of batteries of, for example, xEVs, by the batteries being made swappable. While xEVs are mentioned as an example where the batteries are used, the batteries may be installed in all kinds of load facilities, such as construction machines, agricultural machines, and household electrical appliances, without being limited to vehicles.

A "battery" referred to herein may be a secondary battery, such as a lithium-ion battery, or an assembled battery including secondary batteries. For example, a "battery" may be a "cell" referring to a single battery, a "module" referring to an assembled battery including plural cells assembled together, or a "pack" referring to an assembled battery including plural modules assembled together.

As illustrated in FIG. 1, the battery sharing system 1 may include a server apparatus 10 and stations 30A to 30N. In a case where the stations 30A to 30N do not need to be individually distinguished from one another, the stations 30A to 30N may each be referred to as a "station 30".

The server apparatus 10 and the stations 30 may be communicably connected to each other via any network NW. The network NW may be wired or wireless and may be implemented by any technology, such as Internet technology, industrial communication standards, or power saving wireless communication standards for Internet of Things (IoT).

The server apparatus 10 is an example of an information processing apparatus that provides the battery sharing service. For example, the server apparatus 10 may provide the battery sharing service as a cloud service by being implemented as a Platform as a Service (PaaS) application or a Software as a Service (SaaS) application. In addition, the server apparatus 10 may be implemented as a server that provides a battery sharing function on premises, the battery sharing function implementing the battery sharing service.

The stations 30 correspond to an example of charging facilities that implement swapping of batteries with reduced amounts of charge and charged batteries. The stations 30 each have plural slots where batteries are able to be attached to and detached from. The stations 30 enable charging of a battery inserted in a vacant slot of the plural slots and removal of a fully charged battery from a slot where charging has finished.

### Battery Swap

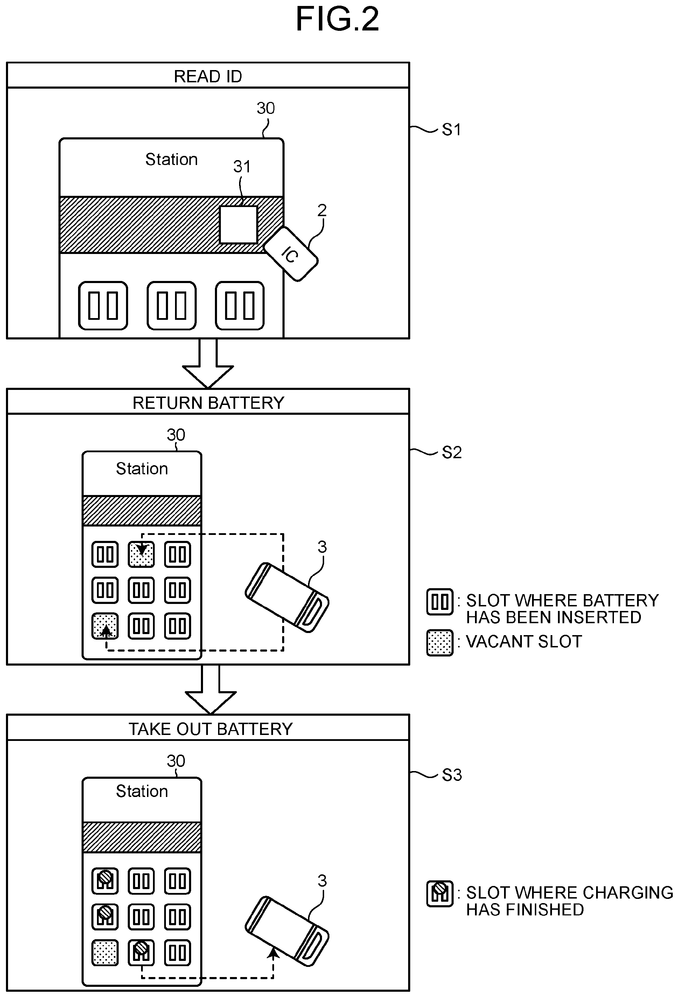

FIG. 2 is a schematic diagram illustrating an example of a battery swap. As illustrated in FIG. 2, at the station 30, identification information on a user who uses the battery sharing service, for example, user identification (ID), is read (Step S1).

For example, the user ID recorded in an integrated circuit (IC) card 2 carried by the user is read by an information reading unit 31 at the station 30 through operation of the IC card 2 being brought closer to the information reading unit 31.

In addition to user authentication on whether or not the user is a registered user who has been registered beforehand, fee payment for payment of a fee for use of the battery sharing service is executed, by use of the user ID thus read by the information reading unit 31.

Thereafter, a battery 3 removed from a vehicle, such as an EV, is returned, by the battery 3 being inserted in a vacant slot of the plural slots that the station 30 has, the vacant slot having no battery inserted therein (Step S2).

When the battery 3 is returned, a display unit associated with the slot, for example, a lamp, may execute display in a display mode for vacant slots distinguished from that for other slots.

After the battery 3 has been returned, a battery 3 is taken out from a slot where charging has finished, the slot being one of the plural slots that the station 30 has (Step S3). "Charging having been finished" may refer to, for example, a fully charged state, but may be not necessarily a fully charged state. For example, a slot having a battery inserted therein may be identified as a slot where charging has finished, the battery having a state of charge (SOC) at a lower limit value of 95% or more.

The battery 3 taken out from the slot where charging has finished is installed in the vehicle of the user, for example. A swap of the battery 3 is thus enabled by the operation from Step S1 to Step S3.

FIG. 2 illustrates an example of a battery swap by a user who has been registered beforehand, but of course, a new user may perform a battery swap.

### Magnetic Field Distribution

Although xEVs have come into wide use, in one aspect, in addition to genuine products manufactured by manufacturers, non-genuine products that are not genuine products are being sold and used as batteries for xEVs. For example, non-genuine products include imitation products each imitating, in addition to the appearance of a genuine module or a housing of a genuine pack, a two-dimensional code linked to management information, such as a battery passport, for management of a life cycle of the battery from procurement of materials to recycling.

From this aspect, the server apparatus 10 according to the first embodiment executes authenticity determination on whether or not a battery is a genuine product upon a swap of the battery. For example, the authenticity determination may be executed by comparison between: battery characteristics of a genuine battery, the battery characteristics serving as reference; and battery characteristics measured from a battery to be identified.

The following description is on an example where the authenticity determination is executed by use of a magnetic field distribution of a battery, the magnetic field distribution being an example of battery characteristics of a battery. For example, the station 30 may acquire a magnetic field distribution of the battery 3 that has been returned at Step S2 illustrated in FIG. 2, from the battery 3.

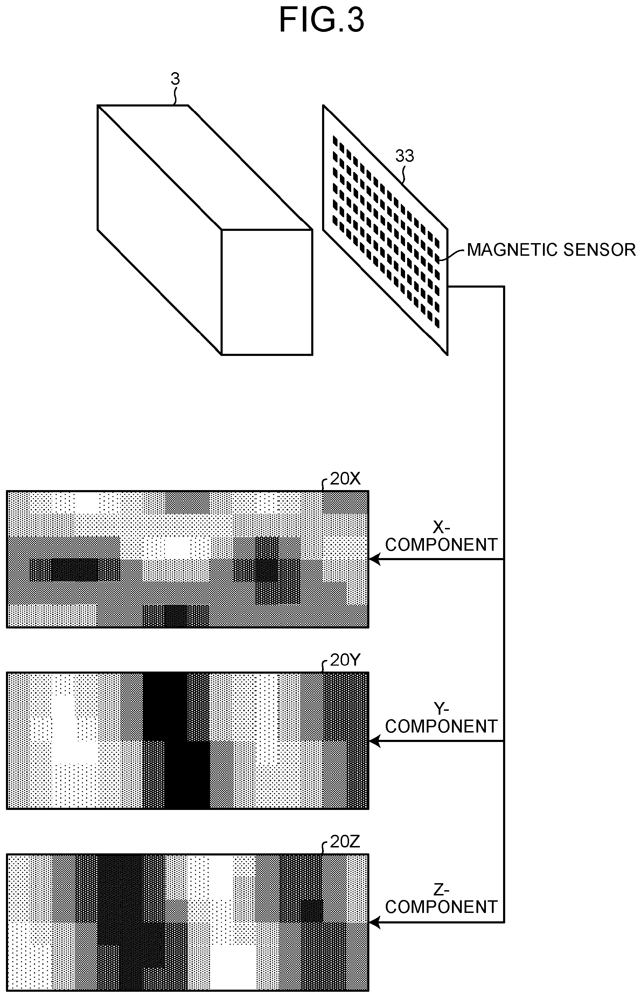

FIG. 3 is a schematic diagram illustrating an example of measurement of a magnetic field distribution of a battery. As illustrated in FIG. 3, the magnetic field distribution of the battery 3 is measured by a measurement unit 33 implemented by magnetic sensors in a two-dimensional array. For example, in the example illustrated in FIG. 3, the measurement unit 33 is implemented by arrangement of the magnetic sensors in an array of 6 rows by 16 columns on a side surface of the battery 3 inserted in the slot of the station 30.

A set of measured values measured by these magnetic sensors of 6 rows by 16 columns, for example, a magnetic flux density map, is acquired as a magnetic distribution 20 of the battery 3. For example, in a case where the measurement unit 33 is implemented by triaxial magnetic sensors, a magnetic field distribution 20X of an X-component, a magnetic field distribution 20Y of a Y-component, and a magnetic field distribution 20Z of a Z-component are acquired as the magnetic field distribution 20 of the battery 3.

Such a magnetic field distribution of a battery is affected by deterioration over time. Therefore, in terms of implementing authenticity determination addressing the temporal change in battery characteristics of a battery, in one aspect, reference battery characteristics are updated over time.

FIG. 3 is just an example, and the measurement unit 33 may be implemented by monoaxial magnetic sensors or biaxial magnetic sensors, and the magnetic sensors may be implemented in any array, for example, a one-dimensional array. For example, the magnetic sensors may be analog elements or digital elements. Each magnetic element is, for example: a Hall element; a magnetoresistance element, such as an anisotropic magnetoresistance (AMR) sensor, a giant magnetoresistance (GMR) sensor, or a tunnel magnetoresistance (TMR) sensor; a magneto-impedance element, such as a magneto-impedance (MI) sensor; a fluxgate; or a thin film magnetic element utilizing the anomalous Hall effect and using a topological magnetic substance. In a case where an AC current is flowing through a target to be measured, a pickup coil may be used as the magnetic element.

### One Aspect of Problems

As described above in the Description of the Related Art section, increasing the frequency of update of the reference to be used in the authenticity determination does not necessarily improve the precision of the authenticity determination. For example, when battery characteristics of a battery are measured, disturbances from the surrounding environment other than the battery are superposed on the battery characteristics measured and updating the reference frequently (for example, every time) with battery characteristics acquired completely newly may thus cause outliers to be set as the reference and reduce the precision of the authenticity determination. By contrast, if the frequency of update of the reference is too low, it will be difficult for the influence of the deterioration of the battery over time to be reflected in the reference and the precision of the authenticity determination may thus be reduced.

### One Aspect of Problem Solving Approach

The server apparatus 10 according to the first embodiment thus provides a reference update function of updating a reference magnetic field distribution to be referred to in authenticity determination of a battery in a case where a condition for updating the reference magnetic field distribution is satisfied upon acquisition of a magnetic field distribution of the battery.

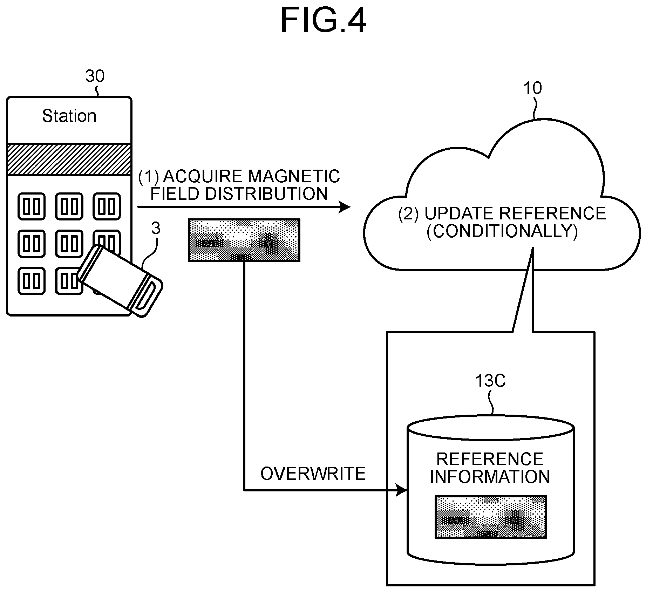

FIG. 4 is a diagram illustrating one aspect of a problem solving approach. As illustrated in FIG. 4, the server apparatus 10 acquires a magnetic field distribution of a battery 3 inserted in a vacant slot of the station 30 (1). The server apparatus 10 then updates, by using the magnetic field distribution of the battery, a reference magnetic field distribution to be referred to in authenticity determination for the battery in a case where a condition for updating the reference magnetic field distribution is satisfied (2) upon acquisition of the magnetic field distribution of the battery.

The server apparatus 10 thus updates the reference magnetic distribution conditionally. For example, a condition that may be set as the condition is that the number of executions of authenticity determination for the battery 3 is equal to or larger than a threshold.

In one aspect, a first condition may be set as a limiting/prohibiting condition for updating reference, the first condition being that an elapsed time period from the last update of the reference is less than a first threshold and the number of executions of authenticity determination for the battery 3 is less than a second threshold. In a case where this first condition is satisfied, in one aspect, influence of both deterioration over time and deterioration due to repetition of charging and discharging is little and difficult to be observed because the elapsed time period from the last update of the reference is short. In this case, update of the reference is limited or prohibited and the reference is thus prevented from being updated too frequently. As a result, the risk of any outlier being set as the reference due to disturbances in measurement of a magnetic field distribution of a battery is able to be reduced.

In another aspect, a second condition may be set as a permitting condition for updating the reference, the second condition being that the elapsed time period from the last update of the reference is less than the first threshold and the number of executions of the authenticity determination for the battery 3 is equal to or larger than the second threshold. In a case where this second condition is satisfied, while the influence of deterioration over time is little because the elapsed time period from the last update of the reference is short, the battery 3 may have deteriorated due to repetition of charging and discharging because the number of executions of authenticity determination is large. In this case, update of the reference is carried out and the reference is thus prevented from being updated too infrequently. As a result, the influence of the deterioration due to the repetition of charging and discharging is able to be reflected in the reference.

In still another aspect, a third condition may be set as a permitting condition for updating the reference, the third condition being that the elapsed time period from the last update of the reference is equal to or longer than the first threshold. In a case where this third condition is satisfied, because the elapsed time period from the last update of the reference is long, the battery 3 may have deteriorated over time and may have an influence. In this case, update of the reference is carried out and the reference is thus prevented from being updated too infrequently. As a result, the influence of the deterioration over time is able to be reflected in the reference.

As described above, the reference update function according to the first embodiment enables balancing between: the risk of taking an outlier; and the merit of reflecting the deterioration over time and/or the deterioration due to the repetition of charging and discharging in the reference. Therefore, the reference update function according to the first embodiment enables optimization of the frequency of update of the reference. Furthermore, the cost of calculation is also able to be reduced because update of the reference is not executed excessively.

An example where the above described reference update function is packaged as one function of the battery sharing service will hereinafter be described as one example, but the reference update function may be provided as a service separate from the battery sharing service.

### Configuration of Server Apparatus 10

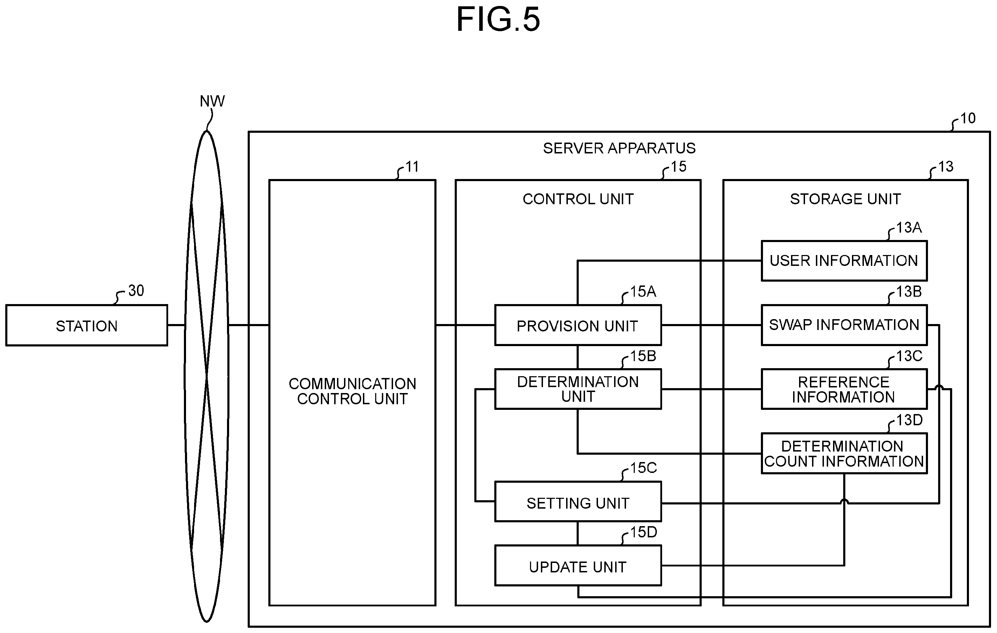

An example of a functional configuration of the server apparatus 10 according to the first embodiment will be described next. FIG. 5 is a first block diagram illustrating the example of the functional configuration of the server apparatus 10. FIG. 5 schematically illustrates blocks related the battery sharing service that the server apparatus 10 has.

As illustrated in FIG. 5, the server apparatus 10 has a communication control unit 11, a storage unit 13, and a control unit 15. FIG. 5 just selectively illustrates functional units related to the battery sharing service and the server apparatus 10 may thus include any other functional unit not illustrated therein.

The communication control unit 11 is a functional unit that controls communication to and from other apparatuses, such as the stations 30. For example, the communication control unit 11 may be implemented by a network interface card. In one aspect, the communication control unit 11 is capable of receiving user IDs and magnetic field distributions of batteries from the stations 30, and outputting a notification of approval or disapproval of a swap of a battery, for example.

The storage unit 13 is a functional unit that stores various kinds of data. For example, the storage unit 13 may be implemented by an internal, external, or auxiliary storage of the server apparatus 10. For example, the storage unit 13 may be implemented by a storage system (cloud) on a network. For example, the storage unit 13 stores user information 13A, swap information 13B, reference information 13C, and determination count information 13D. The user information 13A, the swap information 13B, the reference information 13C, and the determination count information 13D will be described later in conjunction with execution of reference, generation, or registration.

The control unit 15 is a functional unit that performs overall control of the server apparatus 10. For example, the control unit 15 may be implemented by a hardware processor. As illustrated in FIG. 5, the control unit 15 has a provision unit 15A, a determination unit 15B, a setting unit 15C, and an update unit 15D. The control unit 15 may be implemented by, for example, hard wired logic.

The provision unit 15A is a processing unit that provides the above described battery sharing service. For example, the provision unit 15A may correspond to an example of an acquisition unit. In one aspect, upon reception of a user ID from the station 30, the provision unit 15A executes user authentication by referring to the user information 13A stored in the storage unit 13. The user information 13A may be a data set having various kinds of information associated with each user ID, the various kinds of information including payment information on a credit card or electronic money. For example, the user authentication may be implemented by a check of the user ID received from the station 30 against user IDs registered in the user information 13A and determination on whether or not the user is a registered user with a user ID that has been registered in the user information 13A.

In a case where the user authentication is successful, the provision unit 15A outputs an instruction instructing insertion of a battery into a vacant slot, to the station 30. In response to the battery of the user being inserted into a vacant slot of the station 30, the provision unit 15A acquires a magnetic field distribution of the battery, the magnetic field distribution having been measured by the measurement unit 33 of the station 30. The provision unit 15A may also acquire a battery ID of the user's battery inserted in the vacant slot of the station 30. For example, the provision unit 15A may acquire a battery ID recorded in an IC chip installed in the battery. The provision unit 15A may also acquire a battery ID of a battery taken out by the user most recently from a slot where charging has finished by regarding this battery ID as the battery ID of the battery inserted in the vacant slot of the station 30. In this case, the user information 13A may store, for each user ID, a history that is time-series data on battery IDs of batteries taken out by the user from slots where charging has finished and batteries inserted into vacant slots by the user. The time-series data may include times at which the batteries were taken out from the slots where charging has finished or the batteries were inserted into the vacant slots, and identification information on stations (station IDs). In a case where a battery is inserted into a vacant slot under such management of battery IDs, the provision unit 15A may acquire a battery ID of a battery taken out by the user most recently from a slot where charging has finished, from a history of battery IDs corresponding to user IDs that have succeeded in user authentication, by regarding that battery ID as the battery ID of the battery inserted in the vacant slot of the station 30.

After the battery ID and the magnetic field distribution of the battery have been acquired, the provision unit 15A updates a swap interval of the battery, the swap interval being of swap intervals of batteries included in the swap information 13B stored in the storage unit 13.

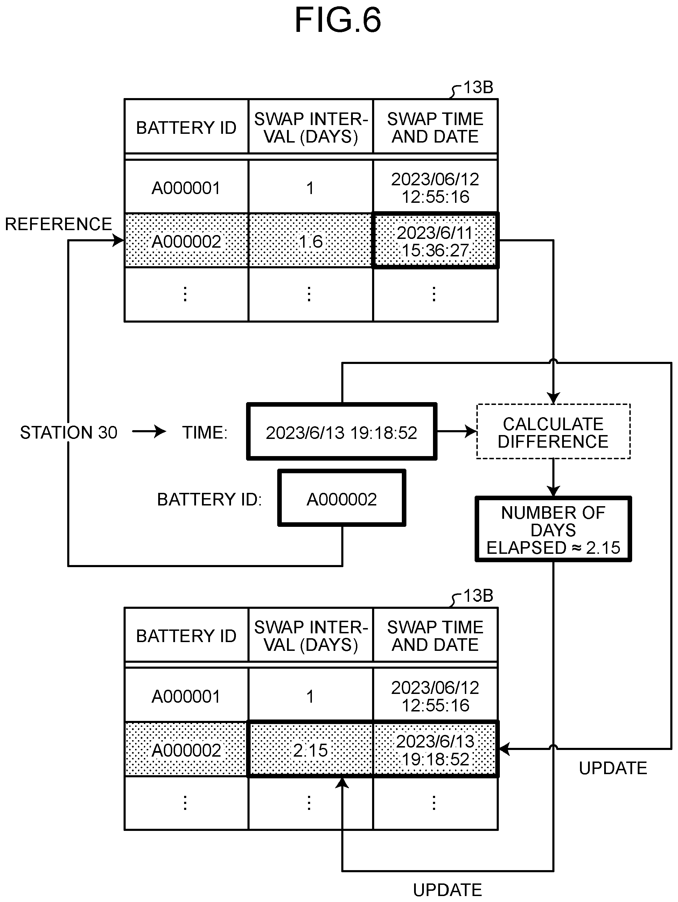

FIG. 6 is a diagram illustrating an example of update of a swap interval for a battery. As illustrated in FIG. 6, the swap information 13B is data having items associated with each battery ID, the items including a swap interval and a swap time and date. A "swap interval" refers to an interval at which a battery is swapped, for example, an interval (in days) between insertion of the battery into a vacant slot and the next insertion of the battery into a vacant slot. Furthermore, a "swap time and date" refers to the latest time and date of time and dates at which the battery was swapped. The top table in FIG. 6 illustrates the swap information 13B before update and the bottom table in FIG. 6 illustrates the swap information 13B after the update.

FIG. 6 illustrates an example where a battery identified by a battery ID, "A000002", is inserted in a vacant slot at 7:18:52 p.m. on June 13, 2023. In this case, the provision unit 15A refers to a data entry in a second row corresponding to the battery ID, "A000002", of data entries included in the swap information 13B. The provision unit 15A then calculates the latest swap interval that is a difference (≈ 2.15 days) between the current time and date, "7:18:52 p.m. on June 13, 2023", and a swap time and date, "3:36:27 p.m. on June 11, 2023", included in the data entry for the battery ID, "A000002". Thereafter, the provision unit 15A updates the swap interval included in the data entry in the second row corresponding to the battery ID, "A000002", with the latest swap interval, "2.15 days". Furthermore, the provision unit 15A updates the swap time and date included in the data entry in the second row corresponding to the battery ID, "A000002", with the latest swap time and date, "7:18:52 p.m. on June 13, 2023".

FIG. 6 illustrates an example where an interval at which magnetic field distributions of the battery are acquired is regarded as being equivalent to the swap interval for the battery, but the first embodiment is not limited to this example. For example, the swap interval for the battery may be an interval between removal of the battery from a slot where charging has finished and insertion of the battery into a vacant slot.

In yet another aspect, the provision unit 15A is capable of processing payment of a fee for a battery swap, in addition to the above described user authentication. For example, for a user who subscribes to a pay-per-use service that charges per use of the service, every time a user ID is acquired from the station 30, the provision unit 15A enables payment of a charging fee corresponding to the pay-per-use service by using payment information corresponding to the user ID. For a user who subscribes to a recurring billing service, for which charging of a fee starts from subscription to the service and payment continues until cancellation of the subscription, for example, a regular billing service or a metered billing service, the provision unit 15A may execute the following processing. For example, for a regular billing service, the provision unit 15A checks whether or not payment of a fee has been completed, the fee being for a time period up to a billing date corresponding to a time point, at which the user ID is acquired from the station 30. For a metered billing service, the provision unit 15A checks whether or not payment of a fee has been completed, the fee corresponding to a cumulative amount of charge at a time point, at which the user ID is acquired from the station 30. In a case where the payment of the fee has been completed as a result of such checking, the provision unit 15A determines that payment is OK. In a case where the payment of the fee has not been completed, the provision unit 15A attempts execution of the payment of the fee and if the payment of the fee succeeds, the provision unit 15A determines that the payment is OK.

In still another aspect, according to a result of authenticity determination by the determination unit 15B described later, the provision unit 15A may output approval or disapproval for a swap of the battery. For example, in a case where a battery inserted in a vacant slot has been determined as a genuine product, the provision unit 15A notifies the station 30 of approval for a swap of the battery. At the station 30 notified of this approval for the swap, removal of a battery from a slot where charging has finished is permitted. On the contrary, in a case where a battery inserted in a vacant slot has been determined as a non-genuine product, the provision unit 15A notifies the station 30 of disapproval for a swap of the battery. At the station 30 notified of this disapproval for the swap, removal of a battery from a slot where charging has finished is prohibited.

The determination unit 15B is a processing unit that executes authenticity determination on whether or not a battery is a genuine product. In one embodiment, the determination unit 15B executes the above described authenticity determination by comparing a magnetic field distribution of a battery of a user, the magnetic field distribution having been acquired by the provision unit 15A, with a magnetic field distribution of a genuine battery registered as reference in the reference information 13C stored in the storage unit 13.

The reference information 13C may be a data set having reference associated with each battery ID identifying a genuine battery, the reference being a magnetic field distribution of the genuine battery. For example, in a case where the measurement unit 33 of the station 30 is implemented by triaxial magnetic sensors, the reference information 13C may store three magnetic field distributions that are a magnetic field distribution of an X-component, a magnetic field distribution of a Y-component, and a magnetic field distribution of a Z-component, in association with each battery ID.

After authenticity determination has been executed, the determination unit 15B updates the number of executions of authenticity determination for the battery, of the numbers of executions of authenticity determination for batteries included in the determination count information 13D stored in the storage unit 13.

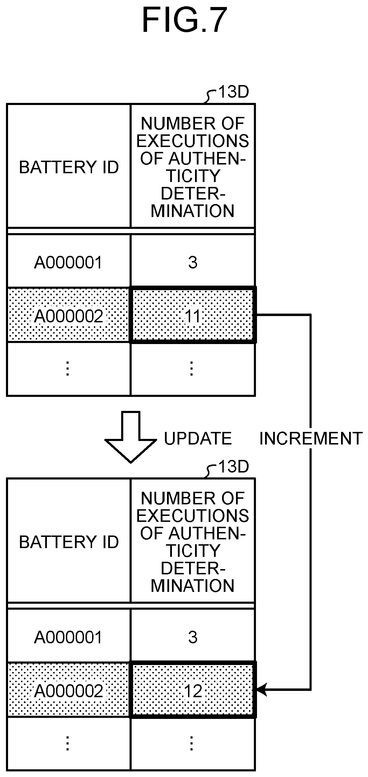

FIG. 7 is a diagram illustrating an example of update of the number of executions of authenticity determination for a battery. As illustrated in FIG. 7, the determination count information 13D is data having an item associated with each battery ID, the item being, for example, the number of executions of authenticity determination. The top table in FIG. 7 illustrates the determination count information 13D before update and the bottom table in FIG. 7 illustrates the determination count information 13D after the update. For example, FIG. 7 illustrates a case where authenticity determination for the battery identified by the battery ID, "A000002", has been executed. In this case, the determination unit 15B refers to a data entry in a second row corresponding to the battery ID, "A000002", of data entries included in the determination count information 13D. By incrementing the number of executions of authenticity determination included in the data entry in the second row corresponding to the battery ID, "A000002", by 1, the determination unit 15B then updates "11" with "12".

The setting unit 15C illustrated in FIG. 5 is a processing unit that sets a threshold to be compared with the number of executions of authenticity determination. In one embodiment, the setting unit 15C sets a threshold Th2 on the basis of a swap interval of the battery, for which the authenticity determination has been executed by the determination unit 15B, the swap interval being of the swap intervals of the batteries included in the swap information 13B.

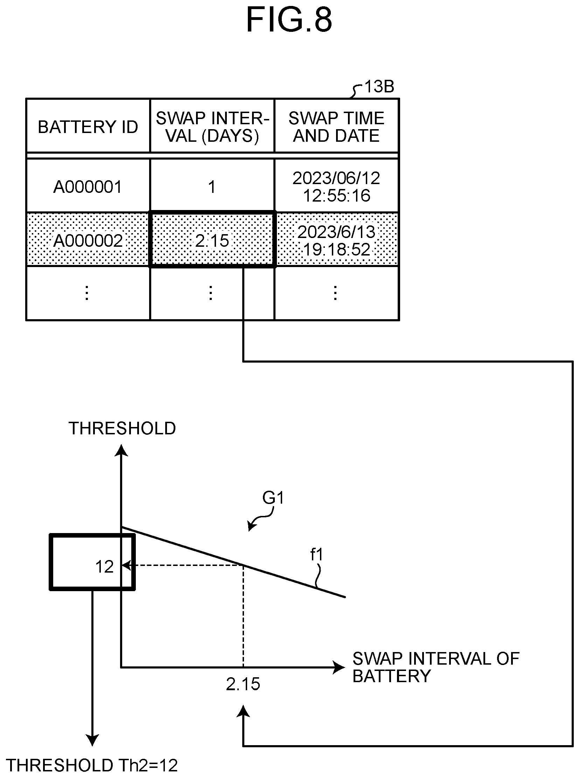

FIG. 8 is a schematic diagram illustrating an example of setting of a threshold. The horizontal axis of a graph G1 illustrated in FIG. 8 represents swap intervals (in days) of a battery and the vertical axis represents thresholds (the numbers of times). As illustrated in FIG. 8, the graph G1 defines a function f1 having thresholds that increase as swap intervals of the battery decrease, in other words, a function f1 having thresholds that decrease as swap intervals of the battery increase. The setting unit 15C is able to set the threshold Th2 to be compared with the number of executions of authenticity determination, according to this function f1. In a case described as an example, authenticity determination for the battery identified by the battery ID, "A000002", is executed, for example. In this case, the setting unit 15C refers to a data entry in a second row corresponding to the battery ID, "A000002", of the data entries included in the swap information 13B. The setting unit 15C then substitutes, as an explanatory variable, the swap interval, "2.15," included in the data entry for the battery ID, "A000002", into the function f1 and thereby calculates the threshold, "12", as an objective variable of the function f1. The setting unit 15C then sets the threshold Th2 to the threshold, "12", calculated as the objective variable of the function f1.

Setting the threshold Th2 to be compared with the number of executions of authenticity determination according to this function f1 enables the threshold to be decreased in a case where the swap interval of the battery is long and the threshold to be increased in a case where the swap interval of the battery is short. Therefore, the threshold is able to be changed dynamically according to the swap interval of the battery, and tuning of the threshold is thus possible, the tuning balancing between: the risk of taking an outlier; and the merit of reflecting the deterioration over time in the reference.

FIG. 8 illustrates, as an example of a function defining correspondence between swap intervals of a battery and thresholds, an example where the function f1 is linear, but the function is not necessarily linear and may be nonlinear. Furthermore, FIG. 8 illustrates an example where correspondence between swap intervals of a battery and thresholds is defined by a function, but the correspondence may be defined by a means other than a function, for example, a lookup table.

The update unit 15D illustrated in FIG. 5 is a processing unit that updates a reference magnetic field distribution by using a magnetic field distribution of a battery, in a case where a condition for updating the reference magnetic field distribution has been satisfied. In one embodiment, the update unit 15D determines whether or not the number of executions of authenticity determination by the determination unit 15B for a battery is equal to larger than the threshold Th2 set by the setting unit 15C, the number of executions being of the determination count information 13D. In a case where the number of executions of authenticity determination for the battery is equal to or larger than the threshold Th2, the update unit 15D starts updating the reference after resetting the number of executions of authenticity determination for the battery. An example where the number of executions of authenticity determination is reset has been described above, but instead, an offset corresponding to the number of executions of authenticity determination may be added to the threshold.

For example, the update unit 15D updates a reference magnetic field distribution by using a magnetic field distribution of a battery that has been determined as a genuine product by the determination unit 15B. For example, the update unit 15D overwrites the reference magnetic field distribution corresponding to the battery ID of a battery inserted in a vacant slot of the station 30, the reference magnetic field distribution being of the reference information 13C, with a magnetic field distribution of a battery that has been determined as a genuine product by the determination unit 15B. The reference magnetic field distribution is thereby updated in an up-to-date manner.

In another example, the update unit 15D may update a reference magnetic field distribution by using plural magnetic field distributions of a battery inserted in a vacant slot of the station 30, the plural magnetic field distributions having been acquired from the battery in the past at plural times.

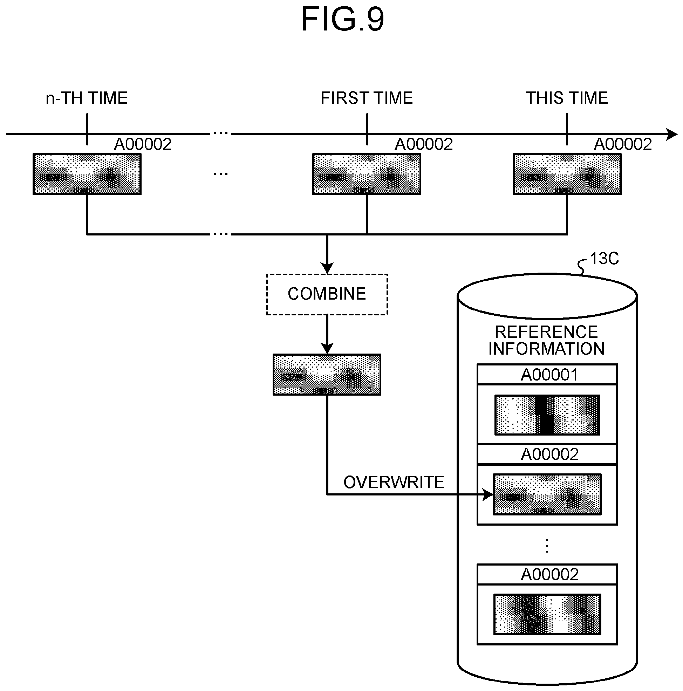

FIG. 9 is a schematic diagram illustrating an example of update of reference. FIG. 9 illustrates an example where a reference magnetic field distribution for a battery ID, "A00002", is updated. As illustrated in FIG. 9, the update unit 15D may use n magnetic field distributions acquired at respective timepoints from the present authenticity determination to authenticity determination performed at a time that is n times before the present authenticity determination. In the example illustrated in FIG. 9, the n magnetic field distributions for the battery ID, "A00002", are able to be combined into one magnetic field distribution by statistical processing for calculating the arithmetic mean, the weighted mean, or the moving average, for example. A magnetic field distribution acquired by such combination may be referred to as a "combined magnetic field distribution". The update unit 15D then overwrites the reference magnetic field distribution corresponding to the battery ID, "A00002", in the reference information 13C, with the combined magnetic field distribution.

FIG. 9 illustrates an example where plural magnetic field distributions are combined into one magnetic field distribution, but the plural magnetic field distributions are not necessarily combined into one magnetic field distribution, and the number of magnetic field distributions to be stored as reference is not necessarily one.

For example, the update unit 15D may estimate, from plural magnetic field distributions acquired in the past at plural times, a distribution that these magnetic field distributions follow, for example, a probability density function, and store the estimated distribution as reference. In another example, the update unit 15D may store all of magnetic field distributions acquired in the past, and store, as reference, a set of measured values that are the latest measured values extracted from measured values of magnetic flux density at measurement points for magnetic flux density by exclusion of outliers that are, for example, values deviated from the mean value ± 3σ. In still another example, the update unit 15D may store, as reference, pseudo data on a magnetic field distribution generated from actually measured data on a magnetic field distribution, by using a machine learning model, such as a variational autoencoder (VAE) or a generative adversarial network (GAN) generator. In yet another example, the update unit 15D calculates a difference between a magnetic field distribution of a battery determined as a genuine product by the determination unit 15B (the present magnetic field distribution) and the last magnetic field distribution of the battery stored as reference. In a case where the difference from the last magnetic field distribution is equal to larger than a threshold, that is, in a case where the change is large, the update unit 15D may withhold or prohibit storing the present magnetic field distribution as the reference. Without being limited to update of reference, the above described application examples may be similarly applied to the measurement unit 33 or machine differences between batteries upon a check of a magnetic field distribution. For example, for a case where a positional shift is generated upon measurement by the measurement unit 33, storing reference corresponding to each measurement environment addresses machine differences between batteries to be measured. For example, the measurement environment may include, in addition to the arrangement pattern of the magnetic sensors, the positional relation (for example, a distance between a specific magnetic sensor and the battery) between the measurement unit 33 and the battery.

### Flow of Processing

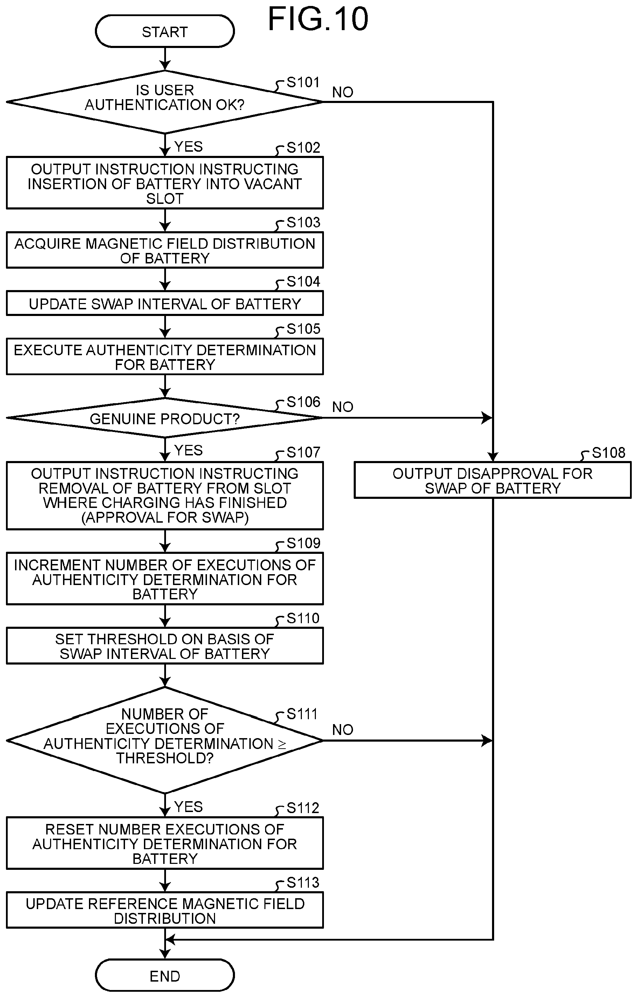

FIG. 10 is a first flowchart illustrating an example of an overall processing procedure. This processing may be, for example, started in a case where a user ID has been received from the station 30. As illustrated in FIG. 10, the provision unit 15A executes user authentication on whether or not the user is a registered user with a user ID that has been registered in the user information 13A, by checking the user ID received from the station 30 against the user IDs registered in the user information 13A (Step S101).

In a case where the user authentication is successful, that is, in a case where the user is a registered user with a user ID that has been registered in the user information 13A (Step S101: Yes), the provision unit 15A outputs an instruction instructing insertion of a battery into a vacant slot, to the station 30 (Step S102).

In response to the battery of the user being inserted in a vacant slot of the station 30, the provision unit 15A acquires a magnetic field distribution of the battery measured by the measurement unit 33 of the station 30 (Step S103).

Subsequently, the provision unit 15A updates a swap interval of the battery, the swap interval being of the swap intervals of the batteries included in the swap information 13B stored in the storage unit 13 (Step S104).

Subsequently, on the basis of a result of comparison between the magnetic field distribution of the battery acquired at Step S103 and a reference magnetic field distribution stored in the reference information 13C, the determination unit 15B performs authenticity determination on whether or not the battery inserted in the vacant slot is a genuine product (Step S105).

In a case where the battery has been determined as a genuine product (Step S106: Yes), the provision unit 15A notifies the station 30 of approval of a swap of the battery (Step S107). At the station 30 notified of this approval for the swap, removal of a battery from a slot where charging has finished is approved.

On the contrary, in a case where the user authentication has failed, or in a case where the battery has been determined as a non-genuine product (Step S101: No, or Step S106: No), the provision unit 15A executes the following processing. That is, the provision unit 15A notifies the station 30 of disapproval of a swap of the battery (Step S108) and ends processing. At the station 30 notified of this disapproval for the swap, removal of a battery from a slot where charging has finished is thus prohibited.

After Step S107 has been executed, the determination unit 15B updates the number of executions of authenticity determination for the battery, of the numbers of executions of authenticity determination for batteries included in the determination count information 13D stored in the storage unit 13 (Step S109).

The setting unit 15C then sets the threshold Th2 on the basis of a swap interval of the battery, for which the authenticity determination has been executed at Step S105, the swap interval being of the swap intervals of the batteries included in the swap information 13B (Step S110).

The update unit 15D then determines whether or not the number of executions of authenticity determination for the battery, for which the authenticity determination has been executed at Step S105, is equal to larger than the threshold Th2 set at Step S110, the number of executions being from the determination count information 13D (Step S111).

In a case where the number of executions of authenticity determination for the battery is equal to or larger than the threshold Th2 (Step S111: Yes), the update unit 15D resets the number of executions of authenticity determination for the battery (Step S112). Thereafter, the update unit 15D updates the reference magnetic field distribution by using the magnetic field distribution of the battery acquired at Step S103 (Step S113) and ends processing.

In a case where the number of executions of authenticity determination for the battery is not equal to or larger than the threshold Th2 (Step S111: No), the processing at Step S112 and Step S113 is skipped and processing is ended.

### One Aspect of Effects

As described above, the server apparatus 10 according to the first embodiment acquires a magnetic field distribution of a battery 3 inserted in a vacant slot of the station 30. In a case where a condition for updating a reference magnetic field distribution referred to in authenticity determination for a battery is satisfied upon acquisition of the magnetic field distribution of the battery, the server apparatus 10 updates the reference magnetic field distribution by using the magnetic field distribution of the battery.

The server apparatus 10 according to the first embodiment thus conditionally updates the reference magnetic field distribution. A condition that may be set, for example, is that the number of executions of authenticity determination for the battery 3 is equal to or larger than a threshold.

In one aspect, the first condition may be set as a limiting/prohibiting condition for updating the reference, the first condition being that an elapsed time period from the last update of the reference is less than the first threshold and the number of executions of authenticity determination for the battery 3 is less than the second threshold. In a case where this first condition is satisfied, in one aspect, the influence of both deterioration over time and deterioration due to repetition of charging and discharging is little and difficult to be observed because the elapsed time period from the last update of the reference is short. In this case, update of the reference is limited or prohibited and the reference is thus prevented from being updated too frequently. As a result, the risk of any outlier being set as the reference due to disturbances in measurement of a magnetic field distribution of a battery is able to be reduced.

In another aspect, the second condition may be set as a permitting condition for updating the reference, the second condition being that the elapsed time period from the last update of the reference is less than the first threshold and the number of executions of authenticity determination for the battery 3 is equal to or larger than the second threshold. In a case where this second condition is satisfied, while the influence of deterioration over time is little because the elapsed time period from the last update of the reference is short, the battery 3 may have deteriorated due to repetition of charging and discharging because the number of executions of authenticity determination is large. In this case, update of the reference is carried out and the reference is thus prevented from being updated too infrequently. As a result, the influence of the deterioration due to the repetition of charging and discharging is able to be reflected in the reference.

In still another aspect, the third condition may be set as a permitting condition for updating the reference, the third condition being that the elapsed time period from the last update of the reference is equal to or longer than the first threshold. In a case where this third condition is satisfied, because the elapsed time period from the last update of the reference is long, the battery 3 may have deteriorated over time and may have an influence. In this case, update of the reference is carried out and the reference is thus prevented from being updated too infrequently. As a result, the influence of the deterioration over time is able to be reflected in the reference.

As described above, the server apparatus 10 according to the first embodiment enables balancing between: the risk of taking an outlier; and the merit of reflecting the deterioration over time and/or the deterioration due to the repetition of charging and discharging in the reference. Therefore, the server apparatus 10 according to the first embodiment enables optimization of frequency of update of the reference.

### Second Embodiment

An example where a threshold to be compared with the number of executions of authenticity determination for a battery is set on the basis of a swap interval of the battery has been described above with respect to the first embodiment, but the threshold is not necessarily set on the basis of the swap interval of the battery. Therefore, in an example described with respect to a second embodiment, a threshold is set on the basis of a frequency, at which a battery is determined as a genuine product at a station 30.

### Configuration of Server Apparatus 20

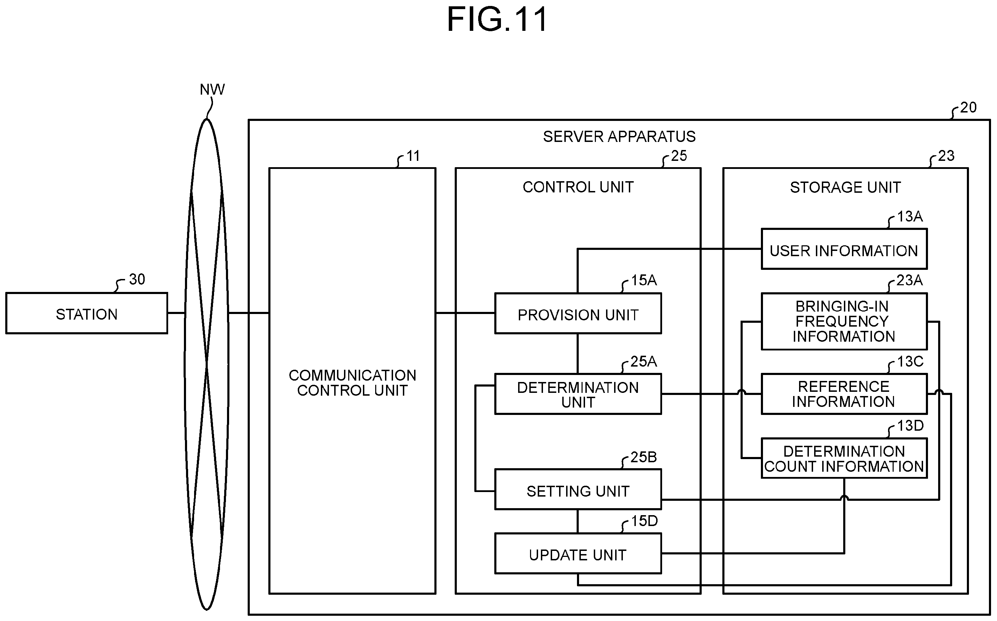

FIG. 11 is a second block diagram illustrating an example of a functional configuration of a server apparatus 20. The same reference signs will be assigned in FIG. 11 to functional units having functions similar to those of the functional units illustrated in FIG. 5 and description thereof will be omitted. As illustrated in FIG. 11, the server apparatus 20 is different from the server apparatus 10 illustrated in FIG. 5 in that the server apparatus 20 has a storage unit 23 storing bringing-in frequency information 23A instead of the swap information 13B. Furthermore, the server apparatus 20 is different in that the server apparatus 20 has a control unit 25 having a determination unit 25A and a setting unit 25B that execute processing, part of the processing being different from that executed by the determination unit 15B and the setting unit 15C illustrated in FIG. 5.

The determination unit 25A is different from the determination unit 15B illustrated in FIG. 5 in that the determination unit 25A additionally performs, after update of the number of executions of authenticity determination for a battery, processing to update the frequency at which a genuine product is brought into the station 30 where the authenticity determination has been executed. The "frequency" referred to herein may include the number of times, a probability, or a probability distribution.

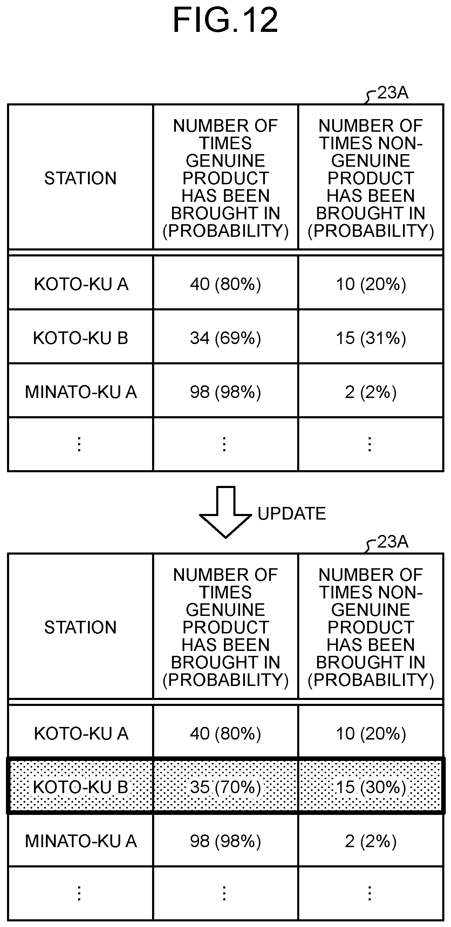

FIG. 12 is a diagram illustrating an example of update of the bringing-in frequency information 23A. As illustrated in FIG. 12, the bringing-in frequency information 23A is data having items associated with each station, the items including the number of times a genuine product has been brought in (probability) and the number of times a non-genuine product has been brought in (probability). This "number of times a genuine product has been brought in (probability)" refers to the number of times (probability) a battery brought into a station 30 by a user has been determined as a genuine product. Furthermore, the "number of times a non-genuine product has been brought in (probability)" refers to the number of times (probability) a battery brought into the station 30 by a user has been determined as a non-genuine product. The top table in FIG. 12 illustrates the bringing-in frequency information 23A before the update and the bottom table in FIG. 12 illustrates the bringing-in frequency information 23A after the update.

FIG. 12 illustrates an example of update of the bringing-in frequency information 23A in a case where "genuine product" is acquired as a result of authenticity determination for the battery having the battery ID, "A000002", brought into a station, "Koto-ku B".

In this case, a data entry for the station, "Koto-ku B", that is, a data entry in a second row, of data entries included in the bringing-in frequency information 23A is updated. That is, because the result of authenticity determination for the battery is "genuine product", the number of times a genuine product has been brought into the station, "Koto-ku B", "34", is incremented by 1. On the contrary, the number of times a non-genuine product has been brought into the station, "Koto-ku B", has not changed and is thus not updated.

The latest number of times a non-genuine product has been brought in, "15, is thus not updated and the latest number of times a genuine product has been brought in, "34", is thus incremented to "35". The sum total of the numbers of times a product has been brought in is incremented from "49 (= 34 + 15)" to "50", although illustration thereof is omitted.

In addition, the probability that a genuine product is brought into the station, "Koto-ku B", is updated from "69%" to "70%" by a calculation of dividing the latest number of times a genuine product has been brought in, "35", by the latest sum total of the numbers of times a product has been brought in, "50". The probability that a non-genuine product is brought into the station, "Koto-ku B", on the other hand, is updated from "31%" to "30%" by a calculation of dividing the latest number of times a non-genuine product has been brought in, "15", by the latest sum total of the numbers of times a product has been brought in, "50".

The setting unit 25B illustrated in FIG. 11 is different from the setting unit 15C illustrated in FIG. 5 in that the setting unit 25B uses a different standard for setting a threshold to be compared with the number of executions of authenticity determination for a battery. That is, the setting unit 25B sets a threshold Th3 on the basis of a genuine product bringing-in frequency at the station 30.

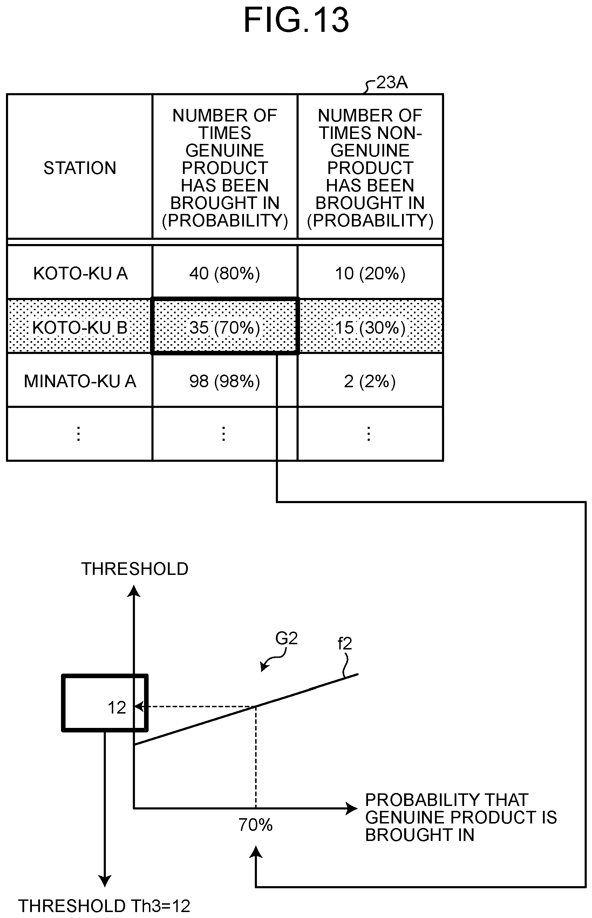

Fig. 13 is a schematic diagram illustrating an example of setting of a threshold. The horizontal axis of a graph G2 illustrated in FIG. 13 represents probabilities (%) that a genuine product is brought in and the vertical axis represents thresholds (the numbers of times). As illustrated in FIG. 13, the graph G2 defines a function f2 having thresholds that increase as probabilities that a genuine product is brought in increase, in other words, a function f2 having thresholds that decrease as probabilities that a genuine product is brought in decrease. The setting unit 25B is able to set the threshold Th3 to be compared with the number of executions of authenticity determination, according to this function f2. For example, the following description is on a case where authenticity determination for a battery is executed at the station, "Koto-ku B". In this case, the setting unit 25B refers to a data entry in a second row corresponding to the station, "Koto-ku B", in the data entries included in the bringing-in frequency information 23A. The setting unit 25B then substitute, as an explanatory variable, the probability that a genuine product is brought in, "70%", included in the data entry for the station, "Koto-ku B", into the function f2 and thereby calculates a threshold, "12", as an objective variable of the function f2. The setting unit 25B then sets the threshold Th3 to the threshold, "12", calculated as the objective variable of the function F2.

Setting the threshold Th3 to be compared with the number of executions of authenticity determination according to the function f2 enables the threshold to be decreased in a case where the probability that a genuine product is brought in is low and enables the threshold to be increased in a case where the probability that a genuine product is brought in is high. Therefore, the threshold is able to be changed dynamically according to the probability that a genuine product is brought in, and tuning of the threshold is enabled, the tuning balancing between: the risk of taking an outlier; and the merit of reflecting deterioration over time in the reference.

FIG. 13 illustrates the function f2 that is linear, as an example of a function defining correspondence between the probability that a genuine product is brought in and the threshold, but the function f2 is not necessarily linear and may be nonlinear. Furthermore, FIG. 13 illustrates an example where the correspondence between the probability that a genuine product is brought in and the threshold is defined by a function, but the correspondence may be defined by a means other than a function, for example, a lookup table.

### Flow of Processing

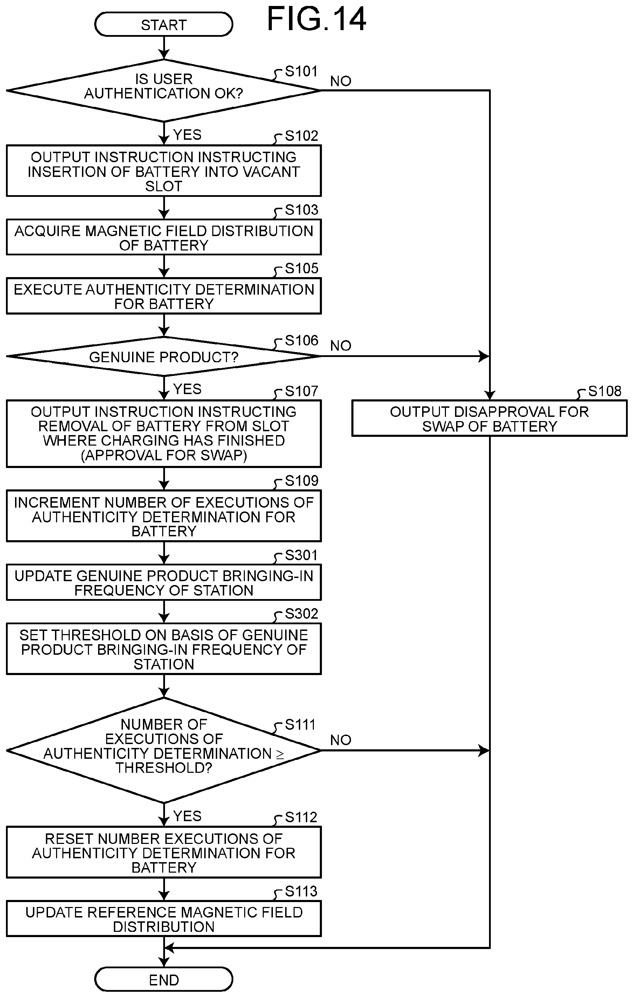

FIG. 14 is a second flowchart illustrating an overall processing procedure. This processing illustrated in FIG. 14 may also be, for example, started in a case where a user ID has been received from a station 30. In FIG. 14, a different step number is assigned to any processing different from that in the flowchart illustrated in FIG. 10 and the same step number is assigned to any processing that is the same as that in the flowchart illustrated in FIG. 10.

As illustrated in FIG. 14, a provision unit 15A executes user authentication on whether a user is a registered user with a user ID that has been registered in user information 13A by checking the user ID received from the station 30 against user IDs registered in the user information 13A (Step S101).

In a case where the user authentication is successful, that is, in a case where the user is a registered user with a user ID that has been registered in the user information 13A (Step S101: Yes), the provision unit 15A outputs an instruction instructing insertion of a battery into a vacant slot, to the station 30 (Step S102).

In response to the battery of the user being inserted in a vacant slot of the station 30, the provision unit 15A acquires a magnetic field distribution of the battery measured by a measurement unit 33 of the station 30 (Step S103).

Subsequently, on the basis of a result of comparison between the magnetic field distribution of the battery acquired at Step S103 and a reference magnetic field distribution stored in reference information 13C, the determination unit 25A performs authenticity determination on whether or not the battery inserted in the vacant slot is a genuine product (Step S105).

In a case where the battery has been determined as a genuine product (Step S106: Yes), the provision unit 15A notifies the station 30 of approval of a swap of the battery (Step S107). At the station 30 notified of this approval for the swap, removal of a battery from a slot where charging has finished is approved.

On the contrary, in a case where the user authentication has failed, or in a case where the battery has been determined as a non-genuine product (Step S101: No, or Step S106: No), the provision unit 15A executes the following processing. That is, the provision unit 15A notifies the station 30 of disapproval of a swap of the battery (Step S108) and ends processing. At the station 30 notified of this disapproval for the swap, removal of a battery from a slot where charging has finished is thus prohibited.

After Step S107 has been executed, the determination unit 25A updates the number of executions of authenticity determination for the battery, of the numbers of executions of authenticity determination included in determination count information 13D stored in a storage unit 13 (Step S109).

Subsequently, the determination unit 25A updates the genuine product bringing-in frequency corresponding to the station 30 where the authenticity determination was executed at Step S105, the genuine product bringing-in frequency being of genuine product bringing-in frequencies included in the bringing-in frequency information 23A (Step S301).

The setting unit 25B then sets the threshold Th3 on the basis of the genuine product bringing-in frequency at the station 30 where the authenticity determination was executed at Step S105, the genuine product bringing-in frequency being of the genuine product bringing-in frequencies included in the bringing-in frequency information 23A (Step S302).

An update unit 15D then determines whether or not the number of executions of authenticity determination for the battery is equal to larger than the threshold Th3 set at Step S302, the battery being the battery, for which the authenticity determination was executed at Step S105, the number of executions being from the determination count information 13D (Step S111).

In a case where the number of executions of authenticity determination for the battery is equal to or larger than the threshold Th3 (Step S111: Yes), the update unit 15D resets the number of executions of authenticity determination for the battery (Step S112). Thereafter, the update unit 15D updates the reference magnetic field distribution by using the magnetic field distribution of the battery acquired at Step S103 (Step S113) and ends processing.

In a case where the number of executions of authenticity determination for the battery is not equal to or larger than the threshold Th3 (Step S111: No), the processing at Step S112 and Step S113 is skipped and processing is ended.

### One Aspect of Effects

As described above, the server apparatus 20 according to the second embodiment also enables optimization of frequency of update of the reference, similarly to the server apparatus 10 according to the first embodiment. Furthermore, similarly to the server apparatus 10 according to the first embodiment, the server apparatus 20 according to the second embodiment also enables the threshold to be dynamically changed according to the frequency that a battery is determined as a genuine product at the station 30, the threshold being a threshold to be compared with the number of executions of authenticity determination.

### Other Embodiments

Although some embodiments of the present invention have been described thus far, the present invention has various applications and may be implemented in various different modes, other than the above described embodiments.

In the example described above with respect to the first and second embodiments, the condition for updating the reference is that the number of executions of authenticity determination for the battery is equal to or larger than a threshold, considering that the present invention is not limited to this example, but is defined by the appended claims.

For example, the update unit 15D may determine whether or not a reference magnetic field distribution is to be updated by using a score output by a machine learning model where a magnetic field distribution of a battery has been input. The "score" referred to herein refers to plausibility of the battery being a genuine product, and may include, for example, a probability, a confidence level, or a likelihood.

Examples of a machine learning model that outputs a score related to classification into a class include a logistic regression model and a support vector machine.

For example, the update unit 15D may update the reference in a case where time-series data on scores output by a machine learning model respectively for plural magnetic field distributions acquired at plural times in the past have a decreasing trend, the machine learning model being a model where the plural magnetic field distributions have been input.

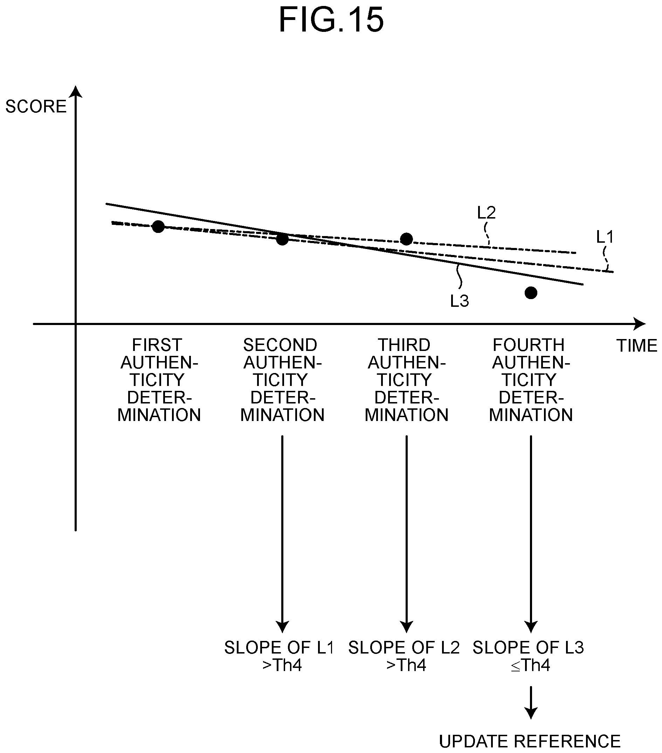

FIG. 15 is a diagram illustrating an example of application of a condition for updating reference. As illustrated in FIG. 15, an approximate straight line is acquired by regression analysis of time-series data on scores from the second authenticity determination. For example, at the time of the second authenticity determination, an approximate straight line L1 represented by a dash-dotted line is acquired by application of regression analysis to a score in the first authenticity determination and a score in the second authenticity determination. Because a slope of this approximate straight line L1 is not equal to or less than a threshold Th4, update of the reference is not executed at the time of the second authenticity determination. Furthermore, at the time of the third authenticity determination, an approximate straight line L2 represented by a dashed and double-dotted line is acquired by application of regression analysis to time-series data on scores from the first authenticity determination to the third authenticity determination. Because a slope of this approximate straight line L2 is also not equal to or less than the threshold Th4, update of the reference is not executed at the time of the third authenticity determination either. Furthermore, at the time of the fourth authenticity determination, an approximate straight line L3 represented by a solid line is acquired by application of regression analysis to time-series data on scores from the first authenticity determination to the fourth authenticity determination. Because a slope of this approximate straight line L3 is equal to or less than the threshold Th4, update of the reference is executed at the time of the fourth authenticity determination.

The condition for updating the reference is able to be determined on the basis of whether or not the slope of an approximate straight line is equal to or less than a specific threshold, that is, whether or not scores have a decreasing trend, without being dependent on just what the scores are. For example, a support vector machine outputs a score normalized to be in a numerical range from -1 to +1 and in a case where a score has a positive sign, the battery is determined as a genuine product. In a case where the score has a positive sign, if scores have a decreasing trend, updating the reference thus enables the reference to be updated before a misjudgment in authenticity determination due to significant influence of deterioration over time occurs.

Any other condition for updating the reference may be set. For example, the update unit 15D may update a reference magnetic field distribution in a case where the cumulative number of charges for a battery is equal to or larger than a threshold. Furthermore, the update unit 15D may update a reference magnetic field distribution in a case where the cumulative amount of charge for a battery is equal to or larger than a threshold. Furthermore, the update unit 15D may update a reference magnetic field distribution in a case where an elapsed time period from the last authenticity determination for a battery is equal to or larger than a threshold. Furthermore, the update unit 15D may update a reference magnetic field distribution every time a magnetic field distribution of a battery is acquired.

An example where the scores described above are derived by a machine learning model has been described above, but without being limited to this example, the scores may be derived by any model, for example, a statistical model. For example, the scores may be derived by any mathematical model, such as a state-space representation model, a transfer function model, a finite impulse response (FIR) model, or a step response model.

### Numerical Values

Specific examples that have been described with respect to the embodiments, for example, the number of the magnetic sensors that the measurement unit 33 of the station 30 has and the method of setting the reference, are just examples and may be modified. Furthermore, the order of the steps in the flowcharts described with respect to the embodiments may be modified so long as no contradiction is caused by the modification.

### System

The processing steps, control steps, specific names, and information including various data and parameters, which have been described above and illustrated in the drawings may be modified in any way unless particularly stated otherwise. For example, any one or more functional units of the provision unit 15A, the determination unit 15B, the setting unit 15C, and the update unit 15D that the server apparatus 10 has may be included in different apparatuses. Furthermore, any one or more functional units of the provision unit 15A, the determination unit 25A, the setting unit 25B, and the update unit 15D that the server apparatus 20 has may be included in different apparatuses.

Furthermore, the components of each apparatus in the drawings have been illustrated functionally and/or conceptually, and do not need to be physically configured as illustrated in the drawings. That is, specific modes of separation and integration of each apparatus are not limited to those illustrated in the drawings. That is, all or part of each apparatus may be configured to be functionally or physically separated or integrated in any units according to various loads and/or use situations. Each configuration may also be a physical configuration.

Furthermore, all or any part of the processing functions performed in each apparatus may be implemented by a central processing unit (CPU) and a program analyzed and executed by the CPU, or may be implemented as hardware by wired logic.

### Hardware

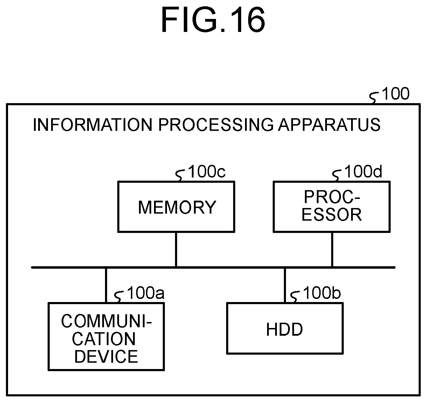

An example of a hardware configuration of a computer described with respect to the first embodiment and the second embodiment will be described next. FIG. 16 is a diagram illustrating the example of the hardware configuration. As illustrated in FIG. 16, an information processing apparatus 100 has a communication device 100a, a hard disk drive (HDD) 100b, a memory 100c, and a processor 100d. These units illustrated in FIG. 16 are connected to one another via a bus, for example.

The communication device 100a is, for example, a network interface card and performs communication to and from another server. The HDD 100b stores, for example: a program that causes the functions illustrated in FIG. 5 or FIG. 11 to operate; and a DB.

The processor 100d causes a process to be operated, the process executing the functions described by reference to FIG. 5 or FIG. 11, by reading, from the HDD 100b, for example, a program that executes processing similar to that by the processing units illustrated in FIG. 5 or FIG. 11, and loading the program into the memory 100c.

This process executes functions similar to those of the processing units that the server apparatus 10 or server apparatus 20 has. For example, the processor 100d reads a program having functions similar to those of the provision unit 15A, the determination unit 15B, the setting unit 15C, and the update unit 15D, from the HDD 100b, for example. The processor 100d then executes a process that executes processing similar to that by the provision unit 15A, the determination unit 15B, the setting unit 15C, and the update unit 15D, for example. Furthermore, the processor 100d reads a program having functions similar to those of the provision unit 15A, the determination unit 25A, the setting unit 25B, and the update unit 15D, from the HDD 100b, for example. The processor 100d then executes a process that executes processing similar to that by the provision unit 15A, the determination unit 25A, the setting unit 25B, and the update unit 15D, for example.

As described above, the information processing apparatus 100 operates as an information processing apparatus that executes an evaluation method, by reading and executing a program. Furthermore, the information processing apparatus 100 may implement functions similar to those according to any one of the above described embodiments by reading the program from a recording medium by means of a medium reading device, and executing the program read. The program referred to herein is not necessarily executed by the information processing apparatus 100. For example, the present invention may be similarly applied to a case where another computer or a server executes the program, or a case where the computer and the server execute the program in corporation with each other.

The program may be distributed via a network, such as the Internet. Furthermore, the program may be recorded in any recording medium and executed by being read by a computer from the recording medium. For example, the recording medium may be implemented by a hard disk, a flexible disk (FD), a CD-ROM, a magneto-optical (MO) disk, or a digital versatile disc (DVD).

## Claims

1. An information processing apparatus (10) comprising:
an acquisition unit (15A) configured to acquire a magnetic field distribution of a battery; and **characterized in** further comprising
an update unit (15D) configured to update, by using the magnetic field distribution of the battery, a reference magnetic field distribution to be referred to in authenticity determination for the battery, in a case where a condition for updating the reference magnetic field distribution is satisfied upon acquisition of the magnetic field distribution of the battery.

2. The information processing apparatus (10) according to claim 1, further comprising:
a determination unit (15B) configured to execute, on the basis of a comparison between the magnetic field distribution of the battery and the reference magnetic field distribution, authenticity determination on whether or not the battery is a genuine product, wherein
the update unit (15D) updates the reference magnetic field distribution by using the magnetic field distribution of the battery determined as the genuine product.

3. The information processing apparatus (10) according to claim 1 or 2, wherein the update unit (15D) updates the reference magnetic field distribution in a case where the number of executions of the authenticity determination for the battery is equal to larger than a threshold.

4. The information processing apparatus (10) according to claim 3, further comprising:
a setting unit (15C) configured to set the threshold on the basis of an interval at which magnetic field distributions of the battery are acquired.

5. The information processing apparatus (10) according to claim 4, wherein the setting unit (15C) sets a larger threshold as the interval decreases.

6. The information processing apparatus (10) according to claim 3, further comprising:
a setting unit (15C) configured to set the threshold on the basis of a frequency at which a battery charged at a station corresponding to a charging source of the battery is determined as a genuine product.

7. The information processing apparatus (10) according to claim 6, wherein the setting unit (15C) sets a larger threshold as the frequency increases.

8. The information processing apparatus (10) according to any one of claims 3 to 7, wherein the update unit (15D) resets the number of executions of authenticity determination for the battery in a case where the reference magnetic field distribution is updated.

9. The information processing apparatus (10) according to claim 1 or 2, wherein the update unit (15D) updates the reference magnetic field distribution in a case where the cumulative number of charges for the battery is equal to larger than a threshold.

10. The information processing apparatus (10) according to claim 1 or 2, wherein the update unit (15D) updates the reference magnetic field distribution in a case where the cumulative amount of charge for the battery is equal to larger than a threshold.

11. The information processing apparatus (10) according to claim 1 or 2, wherein the update unit (15D) updates the reference magnetic field distribution in a case where an elapsed time period from the last execution of the authenticity determination for the battery is equal to longer than a threshold.

12. The information processing apparatus (10) according to claim 1 or 2, wherein the update unit (15D) updates the reference magnetic field distribution every time a magnetic field distribution of the battery is acquired.

13. The information processing apparatus (10) according to claim 1 or 2, wherein the update unit (15D) updates the reference magnetic field distribution in a case where a slope of an approximate straight line of scores is equal to or less than a threshold, the scores being output respectively for plural magnetic field distributions of the battery by a model through input of the plural magnetic field distributions to the model, the plural magnetic field distributions having been acquired respectively at plural times in the past from the battery, the model being a model that outputs a score indicating plausibility of the battery being a genuine product when a magnetic field distribution of the battery is input to the model.

14. The information processing apparatus (10) according to any one of claims 1 to 13, wherein the update unit (15D) updates the reference magnetic field distribution by using plural magnetic field distributions of the battery, the plural magnetic field distributions having been acquired at plural times in the past from the battery.

15. An update method carried out by a computer (100), comprising:
acquiring (S103) a magnetic field distribution of a battery; and **characterized in**
updating (S113), by using the magnetic field distribution of the battery, a reference magnetic field distribution to be referred to in authenticity determination for the battery, in a case where a condition for updating the reference magnetic field distribution is satisfied upon acquisition of the magnetic field distribution of the battery.

16. An update program that causes a computer (100) to execute a process according to claim 15.

## Patentansprüche

1. Informationsverarbeitungsvorrichtung (10), aufweisend:
eine Erlangungseinheit (15A), die konfiguriert ist, um eine Magnetfeldverteilung einer Batterie zu erlangen; und **dadurch gekennzeichnet, dass** sie ferner aufweist
eine Aktualisierungseinheit (15D), die konfiguriert ist, um unter Verwendung der Magnetfeldverteilung der Batterie eine Referenzmagnetfeldverteilung, auf die bei einer Authentizitätsbestimmung für die Batterie Bezug genommen werden soll, in einem Fall zu aktualisieren, in dem eine Bedingung zum Aktualisieren der Referenzmagnetfeldverteilung bei Erlangung der Magnetfeldverteilung der Batterie erfüllt ist.

2. Informationsverarbeitungsvorrichtung (10) gemäß Anspruch 1, ferner aufweisend:
eine Bestimmungseinheit (15B), die konfiguriert ist, um auf der Basis eines Vergleichs zwischen der Magnetfeldverteilung der Batterie und der Referenzmagnetfeldverteilung eine Authentizitätsbestimmung darüber auszuführen, ob die Batterie ein Originalprodukt ist oder nicht, wobei
die Aktualisierungseinheit (15D) die Referenzmagnetfeldverteilung unter Verwendung der Magnetfeldverteilung der Batterie aktualisiert, die als das Originalprodukt bestimmt ist.

3. Informationsverarbeitungsvorrichtung (10) gemäß Anspruch 1 oder 2, wobei die Aktualisierungseinheit (15D) die Referenzmagnetfeldverteilung in einem Fall aktualisiert, in dem die Anzahl von Ausführungen der Authentizitätsbestimmung für die Batterie gleich bis größer als ein Schwellenwert ist.

4. Informationsverarbeitungsvorrichtung (10) gemäß Anspruch 3, ferner aufweisend:
eine Einstelleinheit (15C), die konfiguriert ist, um den Schwellenwert auf der Basis eines Intervalls einzustellen, in dem Magnetfeldverteilungen der Batterie erlangt werden.

5. Informationsverarbeitungsvorrichtung (10) gemäß Anspruch 4, wobei die Einstelleinheit (15C) einen größeren Schwellenwert einstellt, wenn der Abstand abnimmt.

6. Informationsverarbeitungsvorrichtung (10) gemäß Anspruch 3, ferner aufweisend:
eine Einstelleinheit (15C), die konfiguriert ist, um den Schwellenwert auf der Basis einer Frequenz einzustellen, bei der eine Batterie, die an einer Station geladen wird, die einer Ladequelle der Batterie entspricht, als ein Originalprodukt bestimmt wird.

7. Informationsverarbeitungsvorrichtung (10) gemäß Anspruch 6, wobei die Einstelleinheit (15C) einen größeren Schwellenwert einstellt, wenn die Frequenz zunimmt.

8. Informationsverarbeitungsvorrichtung (10) gemäß einem der Ansprüche 3 bis 7, wobei die Aktualisierungseinheit (15D) die Anzahl von Ausführungen der Authentizitätsbestimmung für die Batterie in einem Fall zurücksetzt, in dem die Referenzmagnetfeldverteilung aktualisiert wird.

9. Informationsverarbeitungsvorrichtung (10) gemäß Anspruch 1 oder 2, wobei die Aktualisierungseinheit (15D) die Referenzmagnetfeldverteilung in einem Fall aktualisiert, in dem die kumulative Anzahl von Ladungen für die Batterie gleich bis größer als ein Schwellenwert ist.

10. Informationsverarbeitungsvorrichtung (10) gemäß Anspruch 1 oder 2, wobei die Aktualisierungseinheit (15D) die Referenzmagnetfeldverteilung in einem Fall aktualisiert, in dem die kumulative Ladungsmenge für die Batterie gleich bis größer als ein Schwellenwert ist.

11. Informationsverarbeitungsvorrichtung (10) gemäß Anspruch 1 oder 2, wobei die Aktualisierungseinheit (15D) die Referenzmagnetfeldverteilung in einem Fall aktualisiert, in dem eine abgelaufene Zeitperiode seit der letzten Ausführung der Authentizitätsbestimmung für die Batterie gleich bis länger als ein Schwellenwert ist.

12. Informationsverarbeitungsvorrichtung (10) gemäß Anspruch 1 oder 2, wobei die Aktualisierungseinheit (15D) die Referenzmagnetfeldverteilung jedes Mal aktualisiert, wenn eine Magnetfeldverteilung der Batterie erlangt wird.

13. Informationsverarbeitungsvorrichtung (10) gemäß Anspruch 1 oder 2, wobei die Aktualisierungseinheit (15D) die Referenzmagnetfeldverteilung in einem Fall aktualisiert, in dem eine Steigung einer Näherungsgeraden von Bewertungen gleich oder kleiner als ein Schwellenwert ist, wobei die Bewertungen jeweils für mehrere Magnetfeldverteilungen der Batterie durch ein Modell durch Eingabe der mehreren Magnetfeldverteilungen in das Modell ausgegeben werden, wobei die mehreren Magnetfeldverteilungen jeweils zu mehreren Zeitpunkten in der Vergangenheit von der Batterie erlangt wurden, wobei das Modell ein Modell ist, das eine Bewertung ausgibt, die eine Plausibilität der Batterie angibt, die ein Originalprodukt ist, wenn eine Magnetfeldverteilung der Batterie in das Modell eingegeben wird.

14. Informationsverarbeitungsvorrichtung (10) gemäß einem der Ansprüche 1 bis 13, wobei die Aktualisierungseinheit (15D) die Referenzmagnetfeldverteilung unter Verwendung mehrerer Magnetfeldverteilungen der Batterie aktualisiert, wobei die mehreren Magnetfeldverteilungen zu mehreren Zeitpunkten in der Vergangenheit von der Batterie erlangt wurden.

15. Aktualisierungsverfahren, das durch einen Computer (100) durchgeführt wird, umfassend:
Erlangen (S103) einer Magnetfeldverteilung einer Batterie; und **gekennzeichnet durch**
Aktualisieren (S113) unter Verwendung der Magnetfeldverteilung der Batterie einer Referenzmagnetfeldverteilung, auf die bei einer Authentizitätsbestimmung für die Batterie Bezug genommen werden soll, in einem Fall, in dem eine Bedingung zum Aktualisieren der Referenzmagnetfeldverteilung bei Erlangung der Magnetfeldverteilung der Batterie erfüllt ist.

16. Aktualisierungsprogramm, das einen Computer (100) veranlasst, eine Verarbeitung gemäß Anspruch 15 auszuführen.

## Revendications

1. Appareil de traitement d'informations (10) comprenant :
une unité d'acquisition (15A) configurée pour acquérir une distribution de champ magnétique d'une batterie et **caractérisé en ce qu'**il comprend en outre
une unité de mise à jour (15D) configurée pour mettre à jour, en utilisant la distribution du champ magnétique de la batterie, une distribution de champ magnétique de référence à laquelle se référer dans la détermination de l'authenticité pour la batterie, dans le cas dans lequel une condition de mise à jour de la distribution de champ magnétique de référence est remplie lors de l'acquisition de la distribution de champ magnétique de la batterie.

2. Appareil de traitement d'informations (10) selon la revendication 1, comprenant en outre :
une unité de détermination (15B) configurée pour exécuter, sur la base d'une comparaison entre la distribution de champ magnétique de la batterie et la distribution de champ magnétique de référence, une détermination d'authenticité afin de déterminer si la batterie est, ou non, un produit authentique, dans lequel
l'unité de mise à jour (15D) met à jour la distribution de champ magnétique de référence en utilisant la distribution de champ magnétique de la batterie déterminée comme étant le produit authentique.

3. Appareil de traitement d'informations (10) selon la revendication 1 ou 2, dans lequel l'unité de mise à jour (15D) met à jour la distribution de champ magnétique de référence dans le cas dans lequel le nombre d'exécutions de la détermination d'authenticité pour la batterie est égal à supérieur à un seuil.

4. Appareil de traitement d'informations (10) selon la revendication 3, comprenant en outre :
une unité de réglage (15C) configurée pour définir le seuil sur la base d'un intervalle auquel les distributions de champ magnétique de la batterie sont acquises.

5. Appareil de traitement d'informations (10) selon la revendication 4, dans lequel l'unité de réglage (15C) définit un seuil plus élevé au fur et à mesure que l'intervalle diminue.

6. Appareil de traitement d'informations (10) selon la revendication 3, comprenant en outre :
une unité de réglage (15C) configurée pour définir le seuil sur la base d'une fréquence à laquelle une batterie chargée à une station correspondant à une source de charge de la batterie est déterminée comme étant un produit authentique.

7. Appareil de traitement d'informations (10) selon la revendication 6, dans lequel l'unité de réglage (15C) définit un seuil plus élevé au fur et à mesure que la fréquence augmente.

8. Appareil de traitement d'informations (10) selon l'une quelconque des revendications 3 à 7, dans lequel l'unité de mise à jour (15D) réinitialise le nombre d'exécutions de détermination d'authenticité pour la batterie dans le cas dans lequel la distribution de champ magnétique de référence est mise à jour.

9. Appareil de traitement d'informations (10) selon la revendication 1 ou 2, dans lequel l'unité de mise à jour (15D) met à jour la distribution de champ magnétique de référence dans le cas dans lequel le nombre cumulé de charges pour la batterie est égal à supérieur à un seuil.

10. Appareil de traitement d'informations (10) selon la revendication 1 ou 2, dans lequel l'unité de mise à jour (15D) met à jour la distribution de champ magnétique de référence dans le cas dans lequel la quantité cumulée de charge de la batterie est égale ou supérieure à un seuil.

11. Appareil de traitement d'informations (10) selon la revendication 1 ou 2, dans lequel l'unité de mise à jour (15D) met à jour la distribution de champ magnétique de référence dans le cas dans lequel une période de temps écoulée depuis la dernière exécution de la détermination d'authenticité de la batterie est égale ou supérieure à un seuil.

12. Appareil de traitement d'informations (10) selon la revendication 1 ou 2, dans lequel l'unité de mise à jour (15D) met à jour la distribution de champ magnétique de référence chaque fois qu'une distribution de champ magnétique de la batterie est acquise.

13. Appareil de traitement d'informations (10) selon la revendication 1 ou 2, dans lequel l'unité de mise à jour (15D) met à jour la distribution de champ magnétique de référence dans le cas dans lequel la pente d'une ligne droite approximative de scores est égale ou inférieure à un seuil, les scores étant respectivement délivrés pour plusieurs distributions de champ magnétique de la batterie par un modèle via l'entrée des plusieurs distributions de champ magnétique dans le modèle, les plusieurs distributions de champ magnétique ayant été acquises respectivement à plusieurs moments dans le passé à partir de la batterie, le modèle étant un modèle qui délivre un score indiquant la plausibilité que la batterie soit un produit authentique lorsqu'une distribution de champ magnétique de la batterie est entrée dans le modèle.

14. Appareil de traitement d'informations (10) selon l'une quelconque des revendications 1 à 13, dans lequel l'unité de mise à jour (15D) met à jour la distribution de champ magnétique de référence en utilisant plusieurs distributions de champ magnétique de la batterie, les plusieurs distributions de champ magnétique ayant été acquises à plusieurs moments dans le passé à partir de la batterie.

15. Procédé de mise à jour effectuée par un ordinateur (100), comprenant :
l'acquisition (5103) d'une distribution de champ magnétique d'une batterie ; et **caractérisé par**
la mise à jour (5113), en utilisant la distribution de champ magnétique de la batterie, d'une distribution de champ magnétique de référence à laquelle se référer dans une détermination d'authenticité de la batterie, dans le cas dans lequel une condition de mise à jour de la distribution de champ magnétique de référence est remplie lors de l'acquisition de la distribution de champ magnétique de la batterie.

16. Programme de mise à jour qui amène un ordinateur (100) à exécuter un processus selon la revendication 15.
